(19) Europäisches Patentamt
European Patent Office
Office européen des brevets

(11) EP 1 987 364 B1

(12) EUROPÄISCHE PATENTSCHRIFT

(45) Veröffentlichungstag und Bekanntmachung des Hinweises auf die Patenterteilung:
**10.04.2019 Patentblatt 2019/15**

(51) Int Cl.:
*G01R 27/28* (2006.01)    *G01R 35/00* (2006.01)

(21) Anmeldenummer: **07703353.8**

(22) Anmeldetag: **08.02.2007**

(86) Internationale Anmeldenummer:
**PCT/EP2007/001078**

(87) Internationale Veröffentlichungsnummer:
**WO 2007/096059 (30.08.2007 Gazette 2007/35)**

(54) **VERFAHREN ZUR DARSTELLUNG DER MESSERGEBNISSE EINES NETZWERKANALYSATORS MIT GLEICHZEITIGER TOLERANZANZEIGE**

METHOD FOR REPRESENTATION OF MEASUREMENT RESULTS OF A NETWORK ANALYSER WITH SIMULTANEOUS TOLERANCE DISPLAY

PROCÉDÉ DE REPRÉSENTATION DES RÉSULTATS DE MESURE D'UN ANALYSEUR DE RÉSEAU AVEC AFFICHAGE SIMULTANÉ DES TOLÉRANCES

(84) Benannte Vertragsstaaten:
**DE FR GB**

(30) Priorität: **21.02.2006 DE 102006008063**

(43) Veröffentlichungstag der Anmeldung:
**05.11.2008 Patentblatt 2008/45**

(73) Patentinhaber: **Rohde & Schwarz GmbH & Co. KG**
**81671 München (DE)**

(72) Erfinder:
• **HIEBEL, Michael**
**82256 Fürstenfeldbruck (DE)**
• **PHILIPP, Ute**
**81827 München (DE)**

(74) Vertreter: **Körfer, Thomas**
**Mitscherlich PartmbB**
**Patent- und Rechtsanwälte**
**Sonnenstrasse 33**
**80331 München (DE)**

(56) Entgegenhaltungen:
EP-A1- 0 768 537    WO-A-03/076956
GB-A- 2 155 189

• ANONYMOUS: "Application Note: What is Your Measurement Accuracy? / Vector Network Analyzer" September 2001 (2001-09), ANRITSU , XP002437385 Gefunden im Internet: URL:http://www.eu.anritsu.com/files/11410-00270.pdf> [gefunden am 2007-06-08] das ganze Dokument
• MARKUS ZEIER: "Software automatisiert die Berechnung der Messunsicherheit" METINFO, Bd. 12, Februar 2005 (2005-02), Seiten 20-22, XP002437380 Gefunden im Internet: URL:http://www.metas.ch/root_legnet/Web/Fachbereiche/Elektrizitaet/PDF%20Files/217/metINFO_VNATools.pdf> [gefunden am 2007-06-08] in der Anmeldung erwähnt & ANONYMOS: "Impedance and Network Analysis VNA TOOLS" 19. September 2006 (2006-09-19), SWISS FEDERAL OFFICE OF METROLOGY METAS Gefunden im Internet: URL:http://www.metas.ch/root_legnet/Web/Fachbereiche/Elektrizitaet/PDF%20Files/217/VNAToolsInfo.pdf> [gefunden am 2007-06-08] das ganze Dokument
• WONG K: "Uncertainty analysis of the weighted least squares VNA calibration" ARFTG MICROWAVE MEASUREMENTS CONFERENCE, FALL 2004. 64TH ORLANDO, FL, USA DEC. 2-3, 2004, PISCATAWAY, NJ, USA,IEEE, 2. Dezember 2004 (2004-12-02), Seiten 23-31, XP010793899 ISBN: 0-7803-8952-2

- **"EA GUIDELINES ON THE EVALUATION OF VECTOR NETWORK ANALYSERS (VNA)" Mai 2000 (2000-05), EUROPEAN CO-OPERATION FOR ACCREDITATION, PAGE(S) 1-29 , XP001162754 in der Anmeldung erwähnt das ganze Dokument**
- **CULVER D ET AL: "Traceability for broadband vna and compatibility study of waveguide (WR-10) and imm coaxial measurements" ARFTG CONFERENCE DIGEST, FALL 2002. 60TH DEC. 5 - 6, 2002, PISCATAWAY, NJ, USA,IEEE, 5. Dezember 2002 (2002-12-05), Seiten 11-17, XP010648842 ISBN: 0-7803-8124-6**
- **JÜRG RÜFENACHT ET AL.: "EUROMET.EM.RF-S16 Final Report / Comparison of scattering parameter measurements in the coaxial 2.4 mm line system" November 2004 (2004-11), METAS , XP002437386 Gefunden im Internet: URL:http://www.bipm.org/utils/common/pdf/final_reports/EM/RF/S16/EUROMET.EM.RF-S16.pdf> [gefunden am 2007-06-08] Seite 111 - Seite 115**

**Beschreibung**

Die Erfindung betrifft ein Verfahren zum Bestimmen der Messunsicherheit der Messwerte eines Netzwerkanalysators.

Vektorielle Netzwerkanalysatoren sind sehr komplexe Messsysteme. Entsprechend aufwendig ist die Berechnung der Messunsicherheit der Messwerte. Dazu sind bereits intensive Untersuchungen durchgeführt worden, diese Thematik ist auch Gegenstand aktueller Forschungsaktivitäten, z. B. veröffentlicht in: European co-operation for Accreditation: Guidelines on the Evaluation of Vector Network Analysers (VNA), Publication Reference EA-10/12, May 2000; Rytting, Douglas Kent: Improved RF Hardware and Calibration Methods for Network Analyzers", Hewlett Packard, Network Measurement Divisions, Santa Rosa CA, 1991; Bachmaier, Hand und Stumper, Ulrich: Aktuelle Probleme bei der Weitergabe von HF-Meßgrößen, Vorträge des 139. PTB-Seminars am 13. Mai 1998, PTB-E58, Braunschweig, Juni 1998; Zeiler, Markus: Software automatisiert die Berechnung der Messunsicherheit, metINFO, Vol. 12, No. 2/2005; Vidkjaer, Jens: Network Analyzer Uncertainty Computations for Small-Signal Model Extractions, Technical University of Denmark, Electromagnetic Institute, Lyngby, Denmark, R549, Feb. 1994.

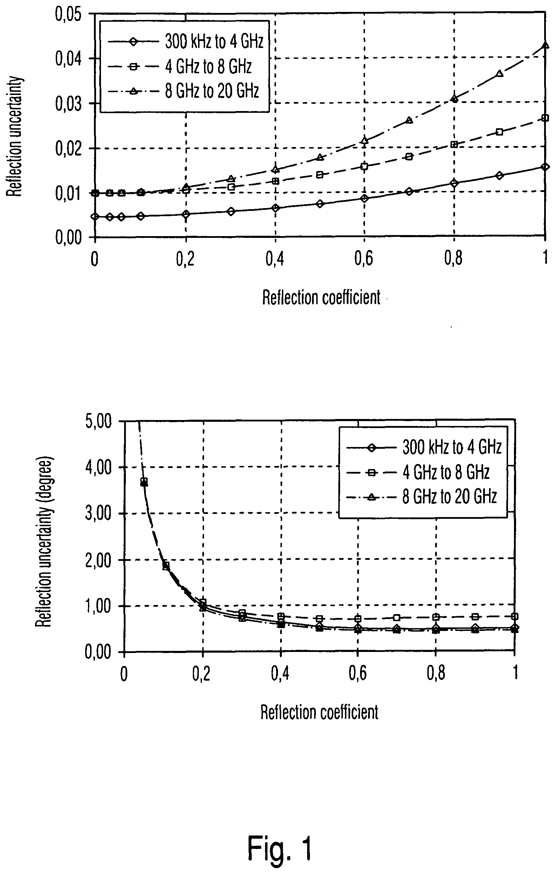

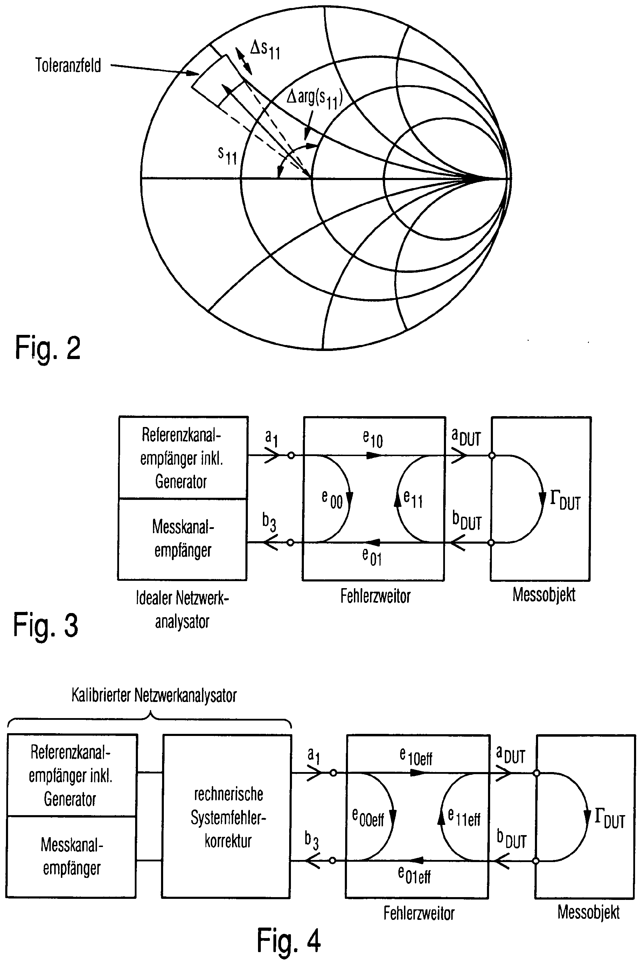

Ein Nachteil dieser bekannten Verfahren ist, dass zur Berechnung der Messunsicherheit viele Einflussgrößen beitragen, die vom Anwender eines Netzwerkanalysators bei der Messung in den internen Rechner des Netzwerkanalysators eingegeben werden müssen bzw. zunächst auf einen externen Rechner in entsprechenden Formeln ausgewertet werden müssen. Es ist zwar bekannt, entsprechende Messunsicherheitskurven, wie sie in Fig. 1 dargestellt sind, nach Betrag und Phase getrennt für die jeweils gewählte Messgröße, beispielsweise für den Reflexionsfaktor, im Datenblatt des Netzwerkanalysators dem Anwender zur Verfügung zu stellen. Selbst für einen geübten Messtechniker ist es jedoch schwierig, daraus für das jeweils vorliegende Messergebnis die zugehörige Messunsicherheit zu ermitteln und darzustellen. Der Anwender muss in Abhängigkeit von der Messfrequenz und dem jeweiligen Messwert die richtige Messunsicherheitskurve auswählen. Dabei entsprechen die für die Darstellung verwendeten Skalen, typischerweise lineare Skalen, nicht immer der vom Anwender für das Messergebnis verwendeten Skalierung (z. B. dB-Skala). Schwierig ist dabei auch meist die Umrechnung einer symmetrischen linearen Toleranzangabe auf eine asymmetrische dB-Toleranzangabe mit unterschiedlicher Ober- und Unterschwelle. All dies ist für den Anwender sehr schwierig und kompliziert. Erschwerend kommt hinzu, dass die Toleranzkurven für Amplitude und Phase getrennt angegeben werden, so dass bei einer komplexen Darstellung die Betrags- und Phasenwerte miteinander verrechnet werden müssen, um die zu einer bestimmten Messwert gehörige Toleranzregion zu ermitteln, wie dies in Fig. 2 für eine übliche komplexe graphische Anzeige dargestellt ist.

Es ist auch schon bekannt, die Messunsicherheit auf einem externen Rechner aus den Kenndaten des Netzwerkanalysators und den gesondert davon in den Rechner eingegebenen Modeldaten für eine ideales Messobjekt die Messunsicherheit zu berechnen und in einer Tabelle in Zuordnung zu ausgewählten Frequenzen anzuzeigen (Anritsu Application Note XP-002437385 "What Is Your Measurement Accuracy?"). Auch hier muss der Anwender in Abhängigkeit von der Messfrequenz für einen am Netzwerkanalysator gemessenen Messwert aus dieser Tabelle die zugehörige Messunsicherheit auswählen und in den Netzwerkanalysator eingeben, sodass auch hierfür die oben geschilderten Nachteile gelten.

Vektorielle Netzwerkanalysatoren werden zwar hauptsächlich für die Streuparameter-Messung S benutzt, daneben jedoch auch zur Messung der Parameter Z, Y, H (Hybrid) bzw. der Gruppenlaufzeit, des VSWR oder zur Messung von Wellengrößen a bzw. b. Die bei der Wellengrößen-Messung auftretenden Messungenauigkeiten (Toleranzen) sind naturgemäß größer, da hierfür keine Möglichkeit einer vorhergehenden Systemfehlerkorrektur durch Kalibrierung besteht. Für solche Wellengrößen-Messungen, wie sie für nichtlineare Messobjekte vorzuziehen sind, ist eine Pegelkalibrierung mit einem zusätzlichen Leistungsmesser erforderlich und zur Toleranzberechnung sind die vom Hersteller bisher im Datenblatt üblichen Messunsicherheitsangaben daher nicht brauchbar.

Es ist daher die Aufgabe der Erfindung, ein Verfahren aufzuzeigen, das es dem Benutzer eines vektoriellen Netzwerkanalysators ermöglicht, auf einfache und unkomplizierte Weise ohne unnötiger Benutzereingaben die jeweilige Messunsicherheit der Messwerte für die verschiedenen Messgrößen zu bestimmen und unmittelbar zusammen mit dem Messwert darzustellen.

Diese Aufgabe wird durch die Merkmale des Anspruchs 1 gelöst. Vorteilhafte Weiterbildungen ergeben sich aus den Unteransprüchen.

Es ist bereits bekannt, die Berechnung der Fehlerkorrekturdaten für einen Netzwerkanalysator unmittelbar in den internen Rechner des Netzwerkanalysators zu verlagern (GB-A-2 155 189). Diese an sich bekannte Verfahrensweise wird gemäß der Erfindung zur unmittelbaren Berechnung der Messunsicherheit für jeden einzelnen Messwert des Netzwerkanalysators benutzt, in dem unmittelbar im internen Rechner des Netzwerkanalysators nach dem bekannten Algorithmen zur Berechnung der Messunsicherheit für jeden einzelnen Messwert die Messwerttoleranz berechnet wird und zwar sind hierbei sowohl der Messwert als auch die für die Berechnung der Messunsicherheit erforderlichen Daten, die je nach Messgröße (S-, Z-, Y-, H-Parameter, Gruppenlaufzeit, VSWR, Wellengrößen und dergleichen) hierfür erforderlich sind, bereits vom Hersteller im Prüffeld in entsprechenden Datenbanken, die dem internen Rechner des Netzwerkanalysators zugeordnet sind, abgespeichert, so dass mit der auf dem internen Rechner des Netzwerkanalysators arbeitenden Berechnungssoftware ohne einer Benutzerinteraktion völlig selbsttätig die Messunsicherheit für den jeweiligen Messwert berechnet werden kann.

Vom Hersteller werden im Prüffeld in diese Datenbanken beispielsweise die Daten über den jeweiligen Typ des Netzwerkanalysators und dessen Optionen abgespeichert, außerdem die Daten für die jeweils wählbaren Geräteeinstellungen wie Messfrequenz, Messbandbreite, Average-Faktor (Faktor zur Mittelwertsbildung), Ausgangspegel des Hochfrequenzgenerators, charakteristische Daten einschließlich Fehlertoleranzen der vom Hersteller verwendeten Kalibrierstandards, Messkabel und Messstecker, charakteristische Daten der Verifikationsstandards einschließlich deren Toleranzen, mit denen im Prüffeld des Herstellers die Kalibrierung des Netzwerkanalysators überprüft wird. Ferner sind abgespeichert die im Prüffeld vom Hersteller daraus ermittelten sog. effektiven Systemdaten, wie sie bisher für die S-Parameter-Darstellung meist in den Datenblättern der Hersteller dokumentiert werden.

Aus diesen bereits vom Hersteller in den Netzwerkanalysator eingegebenen Daten kann mit der entsprechenden Berechnungssoftware auf dem internen Rechner des Netzwerkanalysators dann nach den bekannten Algorithmen für jeden einzelnen Messwert die Messunsicherheit berechnet werden, die dann unmittelbar der sich aus den einzelnen Messwerten ergebenden Messkurve zugeordnet ist und zusammen mit dieser beispielsweise graphisch auf dem Bildschirm als Toleranzschlauch dargestellt wird. Für den Benutzer entfällt damit die schwierige Interpretation einer nur im Datenblatt zugänglichen Messunsicherheitskurve (Fig. 1).

Nur wenn vom Benutzer bei der aktuellen Messung beispielsweise ein anderer Kalibriersatz oder andere Messkabel bzw. Messstecker als ursprünglich vom Hersteller im Prüffeld benutzt werden, müssen vom Benutzer diese von den in den Datenbanken abgespeicherten ursprünglichen Daten abweichenden Daten zusätzlich in den Netzwerkanalysator eingegeben werden, was auf einfache Weise beispielsweise über einen Datenträger erfolgt, der dem betreffenden Messmittel (Kalibriersatz, Messkabel, Messstecker, etc.) beiliegt und dessen Daten in eine Datenbank eingegeben werden, so dass sie für das Rechenprogramm des internen Rechners zugänglich sind.

Alternativ ist auch ein Benutzerdialog zur Eingabe solcher abweichender Messmittel-Daten denkbar, wobei in einer entsprechenden Datenbank des Netzwerkanalysators bereits die Daten aller gängigsten zusammen mit dem Netzwerkanalysator betreibbaren Messmittel wie Kalibrierstandardsätze, Messkabel, Messstecker, etc. aufgelistet sind, die dann nur noch vom Benutzer ausgewählt werden müssen und so unmittelbar dem Rechenprogramm zugänglich sind. Diese zusätzlich vom Benutzer in den Netzwerkanalysator eingegebenen Daten von andersartigen Messmitteln werden mit den Daten der ursprünglich vom Hersteller benutzten Messmittel zu neuen Daten verrechnet, die dann vom internen Rechner für die eigentliche Bestimmung der Messunsicherheit nach den bekannten Algorithmen benutzt werden.

Diese Art der Berechnung und Darstellung der Messunsicherheit unmittelbar zusammen mit den Messkurven ist insbesondere geeignet für die Streuparameter-Darstellung, kann in analoger Weise jedoch auch für die Messung und Darstellung anderer Messgrößen von linearen oder nichtlinearen Messobjekten benutzt werden, wobei es lediglich darauf ankommt, die für diese anderen Messgrößen erforderlichen Daten, die zur Berechnung der entsprechenden Messunsicherheit nach den bekannten Algorithmen erforderlich sind, für den internen Rechner des Netzwerkanalysators über Datenbanken zugänglich zu machen.

Auf diese Weise können auch die Messunsicherheitswerte für Transmissionsmessungen, für die Messung von Impedanzen, der Gruppenlaufzeit oder des VSWR oder auch für Wellengrößenmessungen berechnet und zusammen mit den Messwerten angezeigt werden. Für Wellengrößenmessungen ist eine Pegelkalibrierung mittels eines externen Leistungsmessers erforderlich. Dabei ist der Leistungsmesser neben der HF-Verbindung auch über eine Datenverbindung mit dem Netzwerkanalysator verbunden, so dass auch auf einfache Weise die technischen Daten des Leistungsmessers zum Netzwerkanalysator übertragen und dort dann wieder wie beschrieben zur Berechnung des Messunsicherheit auf den internen Rechner benutzt werden können.

Die Erfindung wird im folgenden an Ausführungsbeispielen unter Bezugnahme auf die Zeichnung näher erläutert. In der Zeichnung zeigen:

Fig. 1    Messunsicherheitskurven für den Reflexionsfaktor $s_{11}$ nach Betrag und Phase für verschiedene Frequenzen,

Fig. 2    Veranschaulichung der Messunsicherheit bei komplexer Ortskurve (Reflexionsfaktor $s_{11}$ im Smithdiagramm),

Fig. 3    Systemfehlermodell bei der OSM-Kalibrierung,

Fig. 4    Systemfehlermodell des eintorkalibrierten Netzwerkanalysators (OSM-Kalibrierung),

Fig. 5    Verarbeitungsschritte zur Messunsicherheitsanzeige,

Fig. 6    Einflussgrößen der Unsicherheitsberechnung Beispiel des Betrages des Reflexionsfaktors und ihre Herkunft,

Fig. 7        intelligente Zoomfunktion,

Fig. 8        Beispiel für die Anzeige,

Fig. 9        Messunsicherheit der b2-Welle bei einem Pegelsweep und

Fig. 10       Messunsicherheit des Parameters $s_{21}$ bei einem Pegelsweep.

Im Abschnitt 1 der nachfolgenden Beschreibung wird anhand der Figuren 3 bis 7 die Messunsicherheitsberechnung für lineare Messobjekte am Beispiels des Betrages des Streuparameters $S_{11}$ beschrieben, wobei außerdem beschrieben wird, wie hierbei unmittelbar vom Anwender selbst die effektiven Systemdaten durch Verifikation bestimmt werden können.

Im Abschnitt 2 ist die Messunsicherheitsbestimmung für nichtlineare Messobjekte beschrieben.

**Abschnitt 1:** Toleranzanalyse für lineare Messungen am Beispiel des Betrags des S-Parameters $s_{11}$

Ein vektorieller Netzwerkanalysator beinhaltet einen HF-Generator zur Erzeugung des Stimulussignals. Zur Trennung von hinlaufender Welle a und rücklaufender Welle b ist pro Messtor ein direktives Element vorhanden. Die Messsignale (typischerweise 4 Signale bei einem Zweitornetzwerkanalysator) werden durch entsprechende Empfänger kohärent (phasensynchron) verarbeitet. Aus den dadurch z.B. über der Frequenz erfassten komplexen Wellengrößen werden die komplexen S-Parameter des Messobjektes berechnet.

Wegen zahlreicher Nichtidealitäten des Messgerätes sowie der Kontaktierung des Messobjektes wird üblicherweise eine Systemfehlerkorrektur angewandt. Sie dient dazu, die systematischen Abweichungen zu kompensieren. Voraussetzung dafür ist eine vektorielle Erfassung der Messgröße. Neben diesen systematischen Abweichungen treten bei jeder Messung auch statistische Ungenauigkeiten etwa durch das Empfängerrauschen oder die Temperaturdrift auf.

Die Basis für die Systemfehlerkorrektur bildet die Kalibrierung. Bei diesem Vorgang werden mit dem zu kalibrierenden Netzwerkanalysator mehrere Kalibrierstandards mit (zum Teil) bekannten Eigenschaften vermessen. Die Auswahl der Standards wird durch das verwendete Kalibrierverfahren vorgegeben. Um die folgenden Ausführungen nicht unnötig kompliziert zu gestalten, wird vereinfachend von einer Eintormessung ausgegangen. Gegebenenfalls weitere am Netzwerkanalysator vorhandenen Messtore sind damit nicht an der Messung beteiligt. Der zu bestimmende Reflexionsfaktor ist durch den Zusammenhang

$$\Gamma_{DUT} = \frac{b_{DUT}}{a_{DUT}} \qquad (1-1)$$

gegeben. Für das OSM - Verfahren werden beispielsweise die Kalibrierstandards Leerlauf (open O), Kurzschluss (short S) und Abschluss (match M) verwendet. Die Abweichung ihrer technischen Daten ist mit den Standards rückführbar dokumentiert. Diese Daten werden dem Netzwerkanalysator als so genannte charakteristische Daten meist durch einen Datenträger mitgeteilt. Aus den charakteristischen Daten der Kalibrierstandards und dem Messergebnis der Kalibrierung berechnet der Analysator die Korrekturterme $e_{00}$, $e_{01}$, $e_{11}$ ... des entsprechenden Fehlermodells (Fig. 3) . Auch die charakteristischen Daten besitzen bezüglich ihrer Rückführbarkeit eine gewisse Unsicherheit. Sie muss im Rahmen der statistischen Toleranzanalyse berücksichtigt werden, worauf später eingegangen wird. Aus dem Signalflussgraphen des Fehlermodells berechnet man den Messwert $M = b_3/a_1$ als Funktion der Fehlerterme $e_{00}$, $e_{01}$, $e_{10}$, $e_{11}$ und des Reflexionsfaktors $\Gamma_{DUT} = b_{DUT}/a_{DUT}$ des Messobjektes.

$$M = \frac{b_3}{a_1} = e_{00} + \frac{e_{01} e_{10} \Gamma_{DUT}}{1 - e_{11} \Gamma_{DUT}} \qquad (1-2)$$

Der vom idealen Netzwerkanalysator mittels der Wellengrößen $a_1$ und $b_3$ aufgezeichnete Messwert M wird durch obige Formel beschrieben. Der Parameter $e_{01}$ wird bei einem funktionsfähigen Netzwerkanalysator niemals den Wert 0 aufweisen. Es ist daher möglich, den Modellparameter $e_{01}$ als $e_{01} = 1$ anzunehmen und seinen Einfluss in den Parameter $e_{10}$ mit einzubringen.

$$M = e_{00} + \frac{e_{10} \Gamma_{DUT}}{1 - e_{11} \Gamma_{DUT}} \qquad (1-3)$$

Führt man die Messung mit den Standards Leerlauf ($\Gamma_{DUT.}=\Gamma_O$), Kurzschluss ($\Gamma_{DUT.}=\Gamma_S$) und Abschluss ($\Gamma_{DUT.}=\Gamma_M$) aus, so erhält man den Messwert $M.=.M_O$, $M.=.M_S$ bzw. $M.=M_M$. Setzt man diese Messwerte zusammen mit den charakteristischen Daten $\Gamma_O$, $\Gamma_S$ und $\Gamma_M$ in Formel (1-3) ein, so erhält man folgendes Gleichungssystem. Vereinfachend wurde $\Gamma_M.=.0$ angenommen, dies ist in vielen praktischen Anwendungen zulässig.

$$M_O = e_{00} + \frac{e_{10}\Gamma_O}{1-e_{11}\Gamma_O} \qquad\qquad (1-4)$$

$$M_S = e_{00} + \frac{e_{10}\Gamma_S}{1-e_{11}\Gamma_S} \qquad\qquad (1-5)$$

$$M_M = e_{00} \qquad\qquad (1-6)$$

Durch Auflösen des Gleichungssystems können die Fehlerterme $e_{00}$, $e_{10}$ und $e_{11}$ aus den Werten $M_O$, $M_S$, $M_M$, $\Gamma_O$, $\Gamma_S$ und $\Gamma_M$ berechnet werden.

$$e_{00} = M_M \qquad\qquad (1-7)$$

$$e_{10} = \frac{(M_O - M_S)(1-e_{11}\Gamma_O)(1-e_{11}\Gamma_S)}{\Gamma_O(1-e_{11}\Gamma_S) - \Gamma_S(1-e_{11}\Gamma_O)} \qquad\qquad (1-8)$$

$$e_{11} = \frac{M_S - e_{00} - e_{10}\Gamma_S}{(M_S - e_{00})\Gamma_S} \qquad\qquad (1-9)$$

Die Fehlerterme $e_{00}$, $e_{10}$, $e_{11}$ können auch als rohe Systemdaten der Eintormessung verstanden werden.

*Tab. 2: Interpretation der Fehlerterme des 3-Term-Verfahrens*

| Rohe Systemdaten | Fehlerterm |
|---|---|
| Unkorrigierter Reflexionsgleichlauf | $e_{10}$ |
| Unkorrigierte Direktivität | $e_{00}$ |
| Unkorrigierte Messtoranpassung | $e_{11}$ |

Die so ermittelten Fehlerterme $e_{00}$, $e_{10}$, $e_{11}$ werden nun dazu verwendet, um eine Systemfehlerkorrektur durchzuführen. Dazu wird Formel (1-3) nach $\Gamma_{DUT}$ aufgelöst, und die komplexen Fehlerterme werden zusammen mit dem komplexen Messwert $M_{DUT}$ eingesetzt. Man erhält den systemfehlerkorrigierten Messwert $\Gamma_{DUT}$.

$$\Gamma_{DUT} = \frac{M_{DUT} - e_{00}}{e_{10} + e_{11}(M_{DUT} - e_{00})} \qquad\qquad (1-10)$$

Systematische Messunsicherheiten werden somit korrigiert. Ihnen überlagert sind jedoch die statistischen Messunsicherheiten. Diese führen dazu, dass die Fehlerterme $e_{00}$, $e_{10}$, $e_{11}$ einen Restfehler aufweisen. Besonders hervorzuheben ist in diesem Zusammenhang die statistische Ungenauigkeit, mit der die Kalibrierstandards rückführbar bekannt sind. Die durch das Messgerät gegebenen Messungenauigkeiten tragen dazu bei, dass die Messung beispielsweise des Leerlaufstandards nicht exakt reproduzierbar ist und damit z.B. der Messwert $M_o$ mit einer Unsicherheit behaftet ist. Es ist deshalb üblich die nach der Kalibrierung verbleibenden Unsicherheiten durch die effektiven Systemdaten zu beschreiben (Fig 4). Sie werden empirisch durch entsprechende Verifikationsverfahren ermittelt. Die Hersteller geben die effektiven Systemdaten z.B. im Datenblatt als Worst-Case Werte an.

Tab. 3: *Beispiel für die effektiven Systemdaten*

| Modellgröße am kalibrierten VNA | Symbol | Beispielwert in dB |
|---|---|---|
| effektive Direktivität | $e_{00eff}$ | > 46 dB |
| effektive Quelltoranpassung | $e_{11eff}$ | > 40 dB |
| effektive Reflexionsgleichlauf | $e_{10eff}$ | < 0,04 dB |
| effektive Lasttoranpassung | $e_{22eff}$ | > 46 dB |
| effektive Transmissionsgleichlauf | $e_{10eff}e_{32eff}$ | < 0,06 dB |

Die im Datenblatt angegebenen effektiven Systemdaten werden nach Gerätetyp (Gerätefamilie, Frequenzbereich) und nach der Hardware-Optionierung der Geräte unterschieden. Exemplarisch wird eine bestimmte Geräteeinstellung und ein bestimmter Kalibriersatz, der vom Hersteller als Zubehör angeboten wird, vorausgesetzt. Gerade diese beiden Voraussetzungen stellen für den Anwender oft eine willkürliche Einschränkungen dar.

Tab. 4: *Einflussgrößen für die effektiven Systemdaten*

| | Beispiel für die Vorgabewerte in einem Datenblatt | Alternative beim Anwender |
|---|---|---|
| **Hardwarekonfiguration:** | | |
| Typ des Netzwerkanalysators | ZVB8 | Unterscheidung für den Anwender meist an Hand des Datenblattes möglich. |
| Relevante Hardwareoptionen | • Eichleitungen<br>• Direkter Generator- und Empfängerzugriff | Unterscheidung für den Anwender meist an Hand des Datenblattes möglich. |
| Verwendete Messkabel | ZV-Z11 | andere hochwertige Messkabel aus dem Zubehörprogramm |
| **Geräteeinstellung:** | | |
| IF-Bandbreite: | 10Hz | jede andere am Gerät verfügbare Bandbreite (z.B. 100kHz) |
| Average-Faktor: | 1 | jeder andere am Gerät verfügbare Average-Faktor z.B. 100 |
| Messtorausgangspegel: | -10 dBm | jeder andere am Gerät einstellbarer Pegel |
| Kalibrierverfahren: | TOM | jedes andere Kalibrierverfahren das vom Gerät unterstützt wird (Bsp. volle 1- und 2-Tor Kalibrierungen) |
| **Kalibriersatz:** | R&S®ZV-Z21 | ein anderes Kalibrierkit z.B. R&S®ZV-Z32 oder von anderen Herstellern |

Die aus dem Datenblatt verfügbaren effektiven Systemdaten müssten also vom Anwender oder einem Programm umgerechnet werden. Wird zum Beispiel eine andere Messbandbreite verwendet, so ist den Messungen ein anderer Rauschpegel überlagert. Aus der äquivalenten Rauschbandbreite $B_{IF}$ und dem Rauschmaß NF berechnet man den Rauschpegel der den Daten aus Tab. 4 und den Rauschpegel der aktuellen Geräteeinstellung entspricht.

$$L_R = -174\,\text{dB} + NF + 10\lg(S_F)\,\text{dB} + 10\lg\left(\frac{B_{IF}}{Hz}\right)\text{dB} \qquad (1-11)$$

Die Formeln (1-4) bis (1-10) können zu einer Formel vereint werden, die den Zusammenhang aus den bei der Kalibrierung gewonnenen Messwerten $M_O$, $M_S$, $M_M$ und den charakteristischen Daten der Standards$_O$, $\Gamma_S$, $\Gamma_M$ sowie dem Messwert M und dem Wert $\Gamma_{DUT}$ beschreibt. Aus dieser Formel können die partiellen Ableitungen nach $M_O$, $M_S$,

$M_M$, $\Gamma_O$, $\Gamma_S$ und $\Gamma_M$ berechnet werden. Diese Ableitungen stellen die Sensitivitätsquotienten $c_m$ dar, mit der die Messwertabweichungen bei der Standardmessung $\Delta M_O$, $\Delta M_S$, $\Delta M_M$ bzw. die Unsicherheiten der charakteristischen Daten $\Delta\Gamma_O$, $\Delta\Gamma_S$, $\Delta\Gamma_M$ in die effektiven Systemdaten eingehen. Man berechnet daraus eine modifizierte Unsicherheit der effektiven Systemdaten

$$u_{\text{eff}} = \sqrt{\left|c_{MM}\Delta M_M\right|^2 + \left|c_{MS}\Delta M_S\right|^2 + \left|c_{MO}\Delta M_O\right|^2 + \left|c_{\Gamma M}\Delta\Gamma_M\right|^2 + \left|c_{\Gamma S}\Delta\Gamma_S\right|^2 + \left|c_{\Gamma O}\Delta\Gamma_O\right|^2}$$

$$(1-12)$$

Zum Anderen kann aus Nominalwerten der effektiven Systemdaten die systematische Messwertabweichung des kalibrierten Netzwerkanalysators berechnet werden. Dieser Berechnung liegt ein ähnliches Fehlermodell wie Fig. 3 zu Grunde. Es ist in Fig. 4 dargestellt.

Das in Fig. 4 dargestellte Fehlerzweitor der effektiven Systemdaten wird prinzipiell durch Formel (1-10) beschrieben. In dieser Formel sind lediglich die Fehlerterme $e_{00}$, $e_{10}$ und $e_{11}$ durch die betreffenden effektiven Systemdaten $e_{00eff}$, $e_{01eff}$ und $e_{11eff}$ zu ersetzen. An die Stelle des Messwertes $M_{DUT}$ tritt der am kalibrierten Messgerät angezeigte Reflexionsfaktor $s_{11M}$.

$$s_{11} = \frac{s_{11M} - e_{00eff}}{e_{10eff} + e_{11eff}(s_{11M} - e_{00eff})} \qquad (1-13)$$

Zu Berechung der Sensitivitätskoeffizienten müssen ähnlich wie in den vorangegangenen Ausführungen die partiellen Ableitungen von Formel (1-13) nach $e_{00eff}$, $e_{01eff}$ und $e_{11eff}$ in dem Punkt $e_{00eff} = 0$; $e_{01eff} = 1$; $e_{11eff} = 0$ bestimmt werden.

$$\frac{\partial s_{11}}{\partial e_{00eff}} = \frac{-e_{10eff}}{\left[e_{10eff} + e_{11eff}(s_{11M} - e_{00eff})\right]^2}\bigg|_{e_{00eff}=0;e_{10eff}=1;e_{11eff}=0} \Rightarrow -1 \qquad (1-14)$$

$$\frac{\partial s_{11}}{\partial e_{10eff}} = \frac{-(s_{11M} - e_{00eff})}{\left[e_{10eff} + e_{11eff}(s_{11M} - e_{00eff})\right]^2}\bigg|_{e_{00eff}=0;e_{10eff}=1;e_{11eff}=0} \Rightarrow -s_{11M} \qquad (1-15)$$

$$\frac{\partial s_{11}}{\partial e_{11eff}} = \frac{-(s_{11M} - e_{00eff})^2}{\left[e_{10eff} + e_{11eff}(s_{11M} - e_{00eff})\right]^2}\bigg|_{e_{00eff}=0;e_{10eff}=1;e_{11eff}=0} \Rightarrow -s_{11M}^2 \qquad (1-16)$$

Für die weitere Rechnung sind lediglich die Beträge der partiellen Ableitungen relevant. Die systematischen Messunsicherheiten sind damit vollständig behandelt. Die statistischen Messunsicherheiten teilen sich in verschiedene Einflussfaktoren auf. Bezüglich des Rauschens unterscheidet man das hochpegelige Rauschen $N_1$ und das niederpegelige Rauschen $N_2$. Hinzu kommt die Nichtlinearität des Analysators, welcher in erster Nährung durch die Größe A beschrieben wird. Die Größen $N_1$, $N_2$ und A sind vom Gerätetyp und den Geräteeinstellungen (IF-Bandreite, Messtorausgangspegel, Average-Faktor,...) abhängig.

$$N = \left|N_1\right|\left|s_{11M}\right| + \left|N_2\right| + \left|A\right|\left|s_{11M}\right| \qquad (1-17)$$

Die effektiven Systemdaten weisen eine Drift auf. In diese Drift kann im vorliegenden Fall auch die Wiederholbarkeit der Steckverbindung mit eingerechnet werden. Die entsprechenden Sensitivitätskoeffizienten gehen aus Formel (1-14) bis (1-16) hervor.

$$\Delta = \left|\Delta_{e00eff}\right| + \left|\Delta_{e10eff}\right|\left|s_{11M}\right| + \left|\Delta_{e11eff}\right|\left|s_{11M}\right|^2 \qquad (1-18)$$

Aus den statistischen Messunsicherheiten $u_{eff}$, N und $\Delta$ und ggf. noch weiterer hier nicht aufgeführter Beiträge, sowie den systematischen Anteilen

$$\left|s_{11}\right| = \left|s_{11M}\right| + \left|e_{00eff}\right| + \left|e_{10eff}\right|\left|s_{11M}\right| + \left|e_{11eff}\right|\left|s_{11M}\right|^2 \qquad (1\text{-}19)$$

berechnet man eine entsprechende Gesamtunsicherheit

$$u_c = \sqrt{\sum_{m=1}^{M}(u_m c_m)^2} \;, \qquad (1\text{-}20)$$

wobei die folgende Tabelle die Zuordnung der Größen $u_m$ und $c_m$ zeigt.

*Tab. 5: Größen zur Formel (1-20)*

| Größe $u_m$ | Sensitivitäts-Koeffizient $c_i$ | Bemerkung |
|---|---|---|
| $u_{eff}$ | | siehe Formel (1-12) |
| $\lvert e_{00eff}\rvert$ | 1 | Betrag der effektiven Direktivität |
| $\lvert e_{10eff}\rvert$ | $\lvert s_{11M}\rvert$ | Betrag des effektiven Reflexionsgleichlaufes |
| $\lvert e_{11eff}\rvert$ | $\lvert s_{11M}\rvert^2$ | Betrag der effektiven Quelltoranpassung |
| $\lvert A\rvert$ | $\lvert s_{11M}\rvert$ | Betrag der Anzeigelinearität der Reflexion |
| $\lvert N_1\rvert$ | $\lvert s_{11M}\rvert$ | Betrag des effektiven hochpegeligen Rauschens |
| $\lvert N_2\rvert$ | 1 | Betrag des effektiven niederpegeligen Rauschens |
| $\lvert \Delta_{e00eff}\rvert$ | 1 | Betrag der Drift der effektiven Direktivität |
| $\lvert \Delta_{e10eff}\rvert$ | $\lvert s_{11M}\rvert$ | Betrag der Drift des effektiven Reflexionsgleichlaufes |
| $\lvert \Delta_{e01eff}\rvert$ | $\lvert s_{11M}\rvert^2$ | Betrag der Drift der effektiven Quelltoranpassung |

Die sich für den Betrag des Streuparameters $S_{11}$ ergebende Gesamt-Messunsicherheit kann durch Formal 1-21 ausgedrückt werden

Gesamtformel für die Messunsicherheit der Refelexionsmessung mit Symboltabelle

$$\left|s_{11}\right| = \left|s_{11M}\right| + \left|e_{00eff}\right| + \left|e_{10eff}\right|\left|s_{11M}\right| + \left|e_{11eff}\right|\left|s_{11M}\right|^2 \qquad \text{(systematisch)}$$

$$+\,\lvert N_1\rvert\,\lvert s_{11M}\rvert + \lvert N_2\rvert \qquad\qquad \text{(Rauschen)} \qquad (1\text{-}21)$$

$$+\,\lvert A\rvert\lvert s_{11M}\rvert \qquad\qquad \text{(Linearität)} \quad (3.5\text{-}26)$$

$$+\,\left|\Delta_{e00eff}\right| + \left|\Delta_{e10eff}\right|\left|s_{11M}\right| + \left|\Delta_{e11eff}\right|\left|s_{11M}\right|^2 \qquad \text{(Drift)}$$

*Symboltabelle*

| Symbol | Größe |
|---|---|
| $\lvert s_{11}\rvert$ | Betrag des Reflexionsfaktors (Messgröße) |
| $\lvert s_{11M}\rvert$ | Am Messgerät angezeigter Betrag des Reflexionsfaktors |
| $\lvert e_{00eff}\rvert_{eff}$ | Betrag der effektiven Direktivität |
| $\lvert e_{10eff}\rvert$ | Betrag des effektiven Reflexionsgleichlaufes |

(fortgesetzt)

| Symbol | Größe |
|---|---|
| $|e_{11eff}|$ | Betrag der effektiven Quelltoranpassung |
| $|A|$ | Betrag der Anzeigelinearität der Reflexion |
| $|N_1|$ | Betrag des effektiven hochpegeligen Rauschens |
| $|N_2|$ | Betrag des effektiven niederpegeligen Rauschens |
| $|\Delta_{e00eff}|$ | Betrag der Drift der effektiven Direktivität |
| $\Delta_{e10eff}$ | Betrag der Drift des effektiven Reflexionsgleichlaufes |
| $\Delta_{e11eff}$ | Betrag der Drift der effektiven Quelltoranpassung |

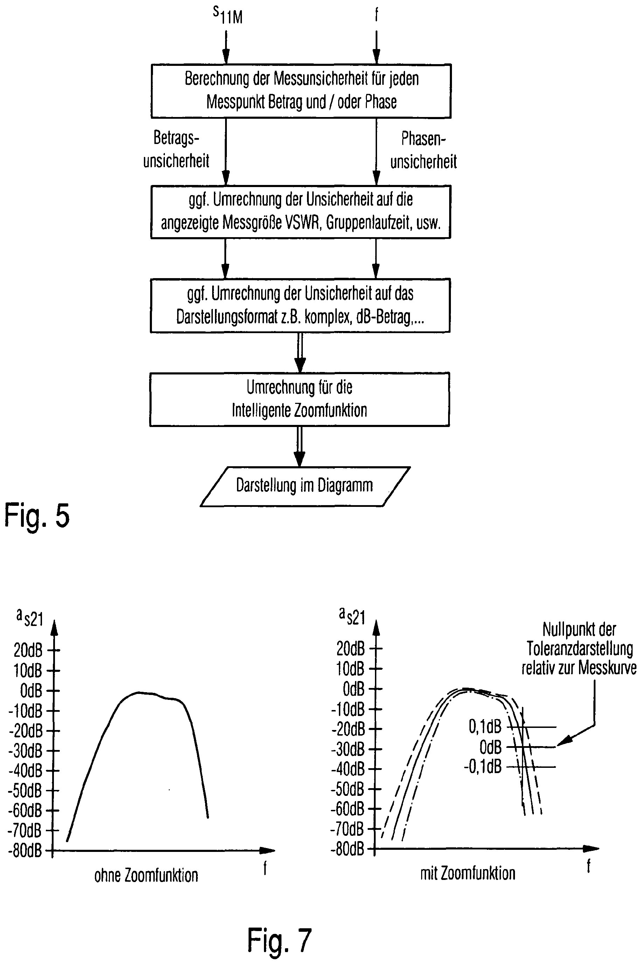

Nach dieser Formal kann im internen Rechner des Netzwerkanalysators mit den dort in entsprechenden Datenbanken abgespeicherten effektiven Systemdaten unter Berücksichtigung der sich aus der Geräteeinstellung ergebenden Werten N ($N_2$ ist z. B. abhängig von der Messbandbreite) sowie der Drift dieser effektiven Systemdaten resultierend aus der Formal 1-18 der sich für die maximale und minimale Messunsicherheit ergebende Betrag des S-Parameters berechnet werden, der also maximal größer bzw. maximal kleiner als der Messwert $S_{11M}$ sein kann. Dieser so berechnete maximal bzw. minimal mögliche Messwert für den Betrag $S_{11}$ wird für sämtliche nebeneinander dargestellten Messpunkte der Gesamtkurve des S-Parameters als durchgehender symmetrischer Toleranzschlauch dargestellt, wie dies Fig. 7 zeigt.

Die effektiven Systemdaten, aufgrund derer diese Berechnung der Messunsicherheit erfolgt, werden beispielsweise durch ein bekanntes Verifikationsverfahren im Prüffeld des Herstellers ermitteln und unmittelbar in eine Datenbank des internen Rechners des Netzwerkanalysators eingespeichert. Diese Überprüfung eines kalibrierten Netzwerkanalysators mittels entsprechender Verifikations-Standards (hochgenauer Messobjekte) erfolgt beispielsweise nach den Verifikationsverfahren, wie sie in den Dokumenten DE 10 2004 047 308 A1 bzw. DE 102 11 334 A1 beschrieben sind. Nach diesen Verfahren können auch die für eine Transmissionsmessung erforderlichen effektiven Systemdaten ermittelt werden und dann analog für eine Messunsicherheitsberechnung benutzt werden. Solche Verifikationsmessungen können ähnlich wie bei einer automatischen Kalibrierung ohne Benutzereingriffe durchgeführt werden. Die höchste Genauigkeit wird mit einem Verfahren nach DE 102 11 334 A1 erreicht. Durch Hinzunahme einer Luftleitung kann dieses Verfahren auch zur Transmissionsmessung erweitert werden.

Es ist auch möglich, diese effektiven Systemdaten unmittelbar durch den Benutzer des Netzwerkanalysators selbst zu ermitteln, indem der Benutzer mit geeigneten Verifikationsstandards am kalibrierten Netzwerkanalysator diese Messungen durchführt und daraus dann die effektiven Systemdaten ableitet und in den internen Rechner eingibt. Der Term nach Formal 1-12 entfällt in diesem Fall bei der Toleranzberechnung, ansonsten erfolgt die Berechnung der Messunsicherheit mit diesen so vom Benutzer selbst gewonnenen effektiven Systemdaten wie oben beschrieben. Die Genauigkeit der Verifikationsstandards wird bei der Berechnung entsprechend berücksichtigt, beispielsweise durch entsprechende Zuschläge.

Die Geräteeinstellungen wie der Averagefaktor, die IM-Bandbreite (und die daraus mittels einer Datenbank ermittelte effektive Rauschbandbreite), die Messfrequenz, der Ausgangspegel bzw. der Messwert sind für die erfindungsgemäße Realisierung direkt für die Berechungssoftware ohne eine Benutzerinteraktion zugänglich. Weitere Einflussgrößen die aus Gründen der Übersichtlichkeit in Formel (1-20) nicht näher beschrieben wurden, sind:

- das Verhalten der Messkabel bei Biegung, das durch die S-Parameter $s_{11k}$, $s_{12k}$, $s_{21k}$, $s_{22k}$ beschrieben wird
- die Eigenschaften zusätzlicher, nach der Kalibrierung eingebrachter Adapter $s_{11A}$, $s_{12A}$, $s_{21A}$, $s_{22A}$
- die Qualität (z.B. Unterscheidung SMA/PC 3.5) der Steckverbinder am Messobjekt
- im Messaufbau verwendete Elemente mit Dämpfung

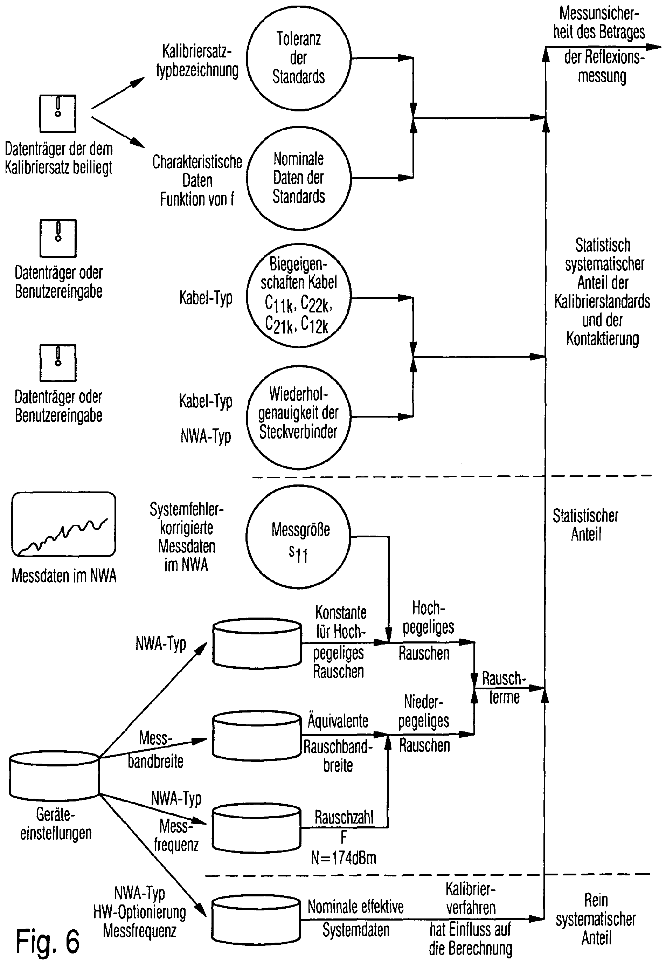

Diese Einflussgrößen können am bequemsten durch einen Datenträger (der dem betreffenden Messzubehör beiliegt) dem Rechenprogramm auf dem Netzwerkanalysator zugänglich gemacht werden. Alternativ ist auch ein Benutzerdialog denkbar, bei dem der entsprechende Typ des Zubehörs ausgewählt wird. Wie im Ablaufdiagramm in Fig. 6 dargestellt, existieren speziell für die Messunsicherheit angelegte Datenbanken im Netzwerkanalysator. Die Datenbanken dienen der Umsetzung der Messparameter in die entsprechenden Größen für die Berechnung der Messunsicherheit. Beispielhaft sei die Umsetzung der IF-Bandbreite in die äquivalente Rauschbandbreite genannt.

Die Konvertierung der effektiven Systemdaten auf andere Geräteeinstellungen wurde hier mittels des Unsicherheitsbeitrags $u_{eff}$ modelliert. Der Genauigkeit dieser Konvertierung sind technische Grenzen gesetzt. Diese Problematik kann zum einen durch eine Einschränkung der wählbaren Messparameter umgangen werden, z.B. Auswahl der IF-Bandbreite bei Messungen mit aktivierter Toleranzanalyse nur im Bereich von 10 Hz bis 1 kHz. Die andere Möglichkeit wäre die effektiven Systemdaten in Abhängigkeit verschiedener Einstellungen in der Datenbank des Netzwerkanalysators abzulegen.

Die Formel (1-20) wird also entsprechend den Geräteeinstellungen ausgewertet. Sie liefert jedoch nur die Messunsicherheit des Betrags des Reflexionsfaktors. Für die Phasenunsicherheit dieser Messgröße sind ähnliche, wie durch Formel (1-1) bis (1-20) vorgestellte Berechnungen durchzuführen. Bei Transmissionsmessungen müssen diese Berechnungen z.B. durch das Verhalten der passiven Messtore (Lasttoranpassung, den gemessenen Transmissions-koeffizienten) erweitert werden. Für die Transmissions-koeffizienten sind ebenfalls entsprechende Messunsicherheitsberechungen nach Betrag und Phase erforderlich um auch für die Transmissionskoeffizienten $s_{21}$, $s_{12}$, ... die Toleranz-balkendarstellung erzeugen zu können.

Messwert z.B. $s_{11M}$ und Frequenzwert (→Datenbank liefert effektive Systemdaten) dienen als Parameter, um für jeden Messwert individuell die zugehörige Messunsicherheit zu berechnen (Fig. 5). Die Unsicherheitsberechnung selbst ist in Fig. 6 am Beispiel des Betrages des Reflexionsfaktors eines Eintormessobjektes veranschaulicht. Die Messunsicherheit ist ggf. für abgeleitete Messgrößen (z.B. VSWR, Gruppenlaufzeit, Impedanz...) umzurechnen. Daran schließt sich eine Konvertierung auf dass entsprechende Anzeigeformat (dB-Betragsdarstellung, lineare Betragsdarstellung, komplexe Darstellung) an. Vor ihrer Darstellung als Kurvenzug sind die Toleranzen umzurechnen, um eine intelligente Zoomfunktion zu ermöglichen. Fig. 7 zeigt die Interpretation der intelligenten Zoomfunktion.

Wegen der unterschiedlichen Größenordnungen der Anzeigeskalen für den Messwert und der Toleranz (Anzeigeskala beispielsweise -80 dB bis 20 dB und Toleranzanzeige beispielsweise 0,1 dB) ist in der linken Darstellung der Messkurve der Toleranzschlauch nicht sichtbar. Durch Anwendung der intelligenten Zoomfunktion wird der Toleranzschlauch lokal um die Messkurve mit einer anderen Skala dargestellt, beispielsweise vergrößert um den Faktor 100, wie dies auf der rechten Seite in Fig. 7 dargestellt ist.

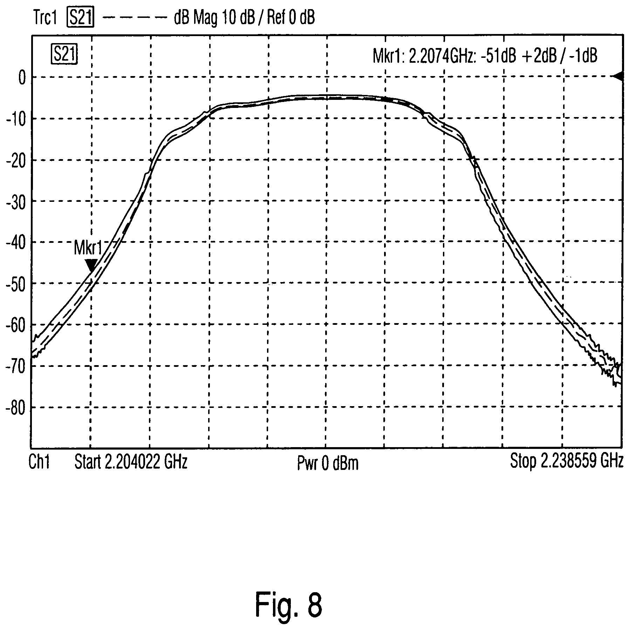

Eine weitere Möglichkeit besteht darin, zusätzliche Messunsicherheitsmarker einzublenden, die ähnlich wie übliche Marker frei längs der Messkurve platziert werden können. Fig. 8 zeigt ein Beispiel hierfür. Neben dem Messwert in der jeweiligen Skalierung wird im zugehörigen Marker-Informationsfeld die betreffende Messunsicherheit digital angezeigt. Bei einer dB-Skalierung wird in der Regel ein asymmetrischer Toleranzschlauch auftreten, weshalb das Marker-Informationsfeld, hier dargestellt im oberen rechten Teil des Anzeigefeldes, in diesem Fall eine getrennte Ober- und Untergrenze aufweist.

**Abschnitt 2:** Toleranzanalyse für nichtlineare Messungen

Bei nichtlinearen Messungen ist das Verhalten des Messobjektes vom anliegenden Pegel abhängig. Durch entsprechende Maßnahmen, wie etwa die Generatorpegelkalibrierung kann die Genauigkeit des Ausgangspegels optimiert werden. Die Messunsicherheitsanalyse umfasst (sofern S-Parameter dargestellt werden) eine Analyse gemäß Abschnitt 1 und 2. Zusätzlich ist die im Folgenden für die Wellengrößen beschriebene Fehleranalyse erforderlich.

Die Genauigkeit des bei der Messung verwendeten Pegels ist entscheidend von dem zur Pegelkalibrierung verwendeten Leistungsmesser abhängig. Da der Leistungsmesser ohnehin zur Pegelkalibrierung neben der HF-Verbindung auch über eine Datenverbindung zur Übertragung der Messwerte mit dem Netzwerkanalysator verbunden wird, können dabei auch die technischen Daten des Leistungsmessers bzw. sein Typ übertragen werden. Sofern nur sein Typ übertragen wird, verwendet der Netzwerkanalysator eine interne Datenbank um daraus die benötigte Genauigkeitsangabe für den Leistungsmesser zu erhalten. Weitere Einflussgrößen entstehen z.B. dadurch, dass zur Messung ein geänderter Pegel verwendet wird (Generatorlinearität) oder dass eine Eichleitung umgeschaltet wird. Auch die Anzahl der Messzyklen bei der Pegelkalibrierung ist von Bedeutung. Aus diesen und weiteren Einflussgrößen kann ähnlich, wie im Abschnitt 1 eine Gesamtunsicherheit für den Ausgangspegel (sprich die Wellengrößen $a_1$, $a_2$, $a_3$, ...) angegeben werden. Neben diesen Wellengrößen ist man aber vor allem an den Ausgangsgrößen des Messobjektes z.B. $b_1$, $b_2$, ... interessiert.

Die Messung nichtlinearer Messobjekte (S-Parameter, Wellengrößen, Wellengrößen-verhältnisse, Harmonische, ...) erfordert eine Toleranzanalyse, bei der die nichtlinearen Eigenschaften des Messobjektes mitberücksichtigt werden müssen. Eine allgemeine Toleranzanalyse gemäß der Fig. 1 ist damit nicht mehr möglich. Denkbar wäre eine quasi allgemeine Toleranzanalyse, zu der jedoch die typischen nichtlinearen Eigenschaften des Messobjektes parametrisiert sein müssen. Auch diese Eigenschaften können eine Streuung aufweisen, weshalb je nach den Eigenschaften des Prüflings ein individuelles Worst-case-Modell erarbeitet werden müsste. Der Arbeitsaufwand und das vom Anwender zu erwartende fachliche Verständnis sind entsprechend groß.

Ein weiteres Ziel der Erfindung ist es, auch für diesen Fall eine möglichst unkomplizierte direkt am Messgerät durchgeführte Toleranzanalyse anzubieten, die ohne unnötige Benutzereingaben oder Modelle auskommt. Das entsprechende Verfahren wird als Invivo-Toleranzanalyseverfahren eingeführt. Das zur Messunsicherheitsanalyse verwendete Programm muss dazu in der Lage sein, die Messung entsprechend zu beeinflussen, um am "lebenden Messobjekt" den dynamischen Einfluss von Stimulusschwankungen (Bsp. Schwankungen der Größen $a_1$, $a_2$....) ermitteln zu können.

Das Verfahren soll am Beispiel einer Transmissionsmessung gezeigt werden. Der tatsächliche Wert a1 wird von der Pegelunsicherheit des Netzwerkanalysators bestimmt. Durch die Pegelkalibrierung kann diese verbessert werden. Trotzdem verbleibt eine Restunsicherheit bezüglich des an das Messobjekt angelegten Pegels. Das Messobjekt wird der Reihe nach mit drei verschiedenen Pegeln angeregt, dem Nominalpegel a1, dem um die untere Unsicherheitsschranke reduzierten Nominalpegel $a_1 - \Delta_{min}$ und dem um die obere Unsicherheitsschranke erhöhten Nominalpegel $a_1 + \Delta_{max}$. Am Messobjektausgang erhält man die drei entsprechenden Ausgangspegel $b_2$, $b_{2min}$, $b_{2max}$. Diese gehen in die weitere empfängerseitige Toleranzberechnung ein.

Die dynamische Toleranzanalyse verzichtet damit auf das zuvor genannte Worst-case-Modell. Das Verfahren setzt die direkte Toleranz-Darstellung an der Messkurve voraus. Damit genügt es, die für den aktuellen Prüfling aus dessen Invivo-Verhalten abgeleiteten Toleranzwerte zu verwenden. Ein Modell für eine ganze Prüflingsserie ist damit überflüssig. Weil für jede Messung ein individuelles automatische Prüflingsmodell verwendet wird, ist die Ausbeute höher, da in die Rechnung keine Worst-case-Annahmen des Prüflingsmodells eingehen.

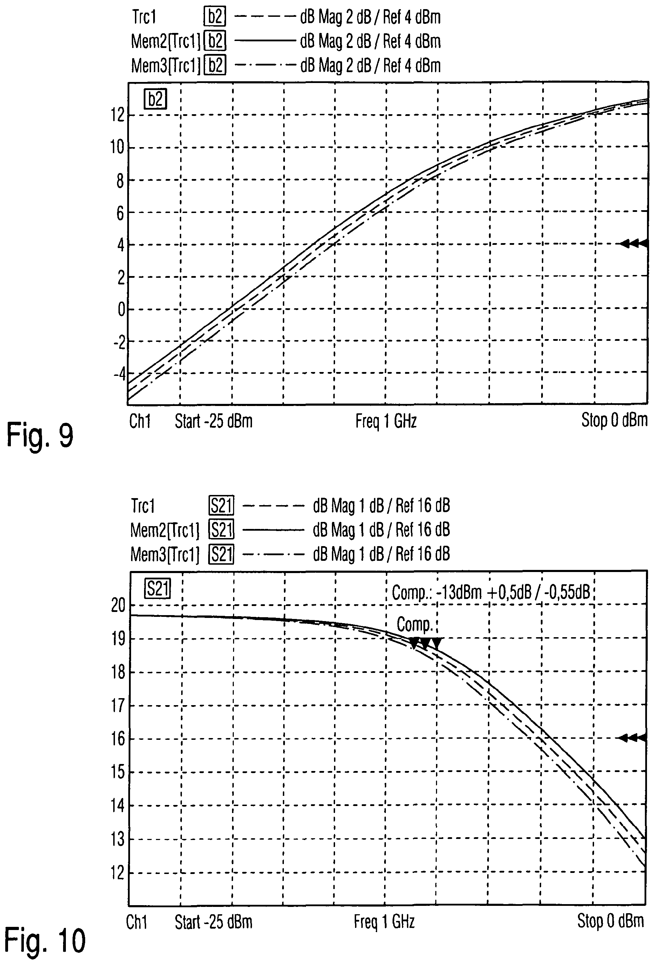

Fig. 9 zeigt ein Beispiel für die $b_2$-Messung an einem Verstärker. Bei dieser Messung kommt hinzu, dass als x-Achse nicht die Frequenz sondern die Eingangsleistung aufgetragen ist (Pegelsweep). Die Toleranz des Pegels $a_1$ wurde hier mit +/-0,5dB gewählt.

Fig. 10 zeigt ein Beispiel für eine Kompressionspunktmessung mit Fehler-analyse. Hier fließen sowohl die Verfahren aus Abschnitt 1 bzw. 2 als auch Abschnitt 3 ein. Das Messergebnis als S-Parameter $s_{21}$ wird unter Anwendung von Systemfehlerkorrektur und Pegelkalibrierung ermittelt.

- Üblicherweise wird die erweiterte Messunsicherheit mit k = 2 angegeben. Das ist dasjenige Intervall, in dem ca. 95 % der Messwerte liegen. Für k = 1 erhält man z.B. das Intervall in dem 68 % der Messwerte liegen. Die Darstellung des Toleranzschlauches kann auch amorph erfolgen. Das heißt die Punktdichte mit der der Schlauch dargestellt wird, ist ein Maß für die Häufigkeit des entsprechenden Wertes. Statt der Punktdichte kann auch eine Falschfarbendarstellung verwendet werden.

- Die Toleranzanalyse kann auch für andere Wobbelbetriebsarten zur Verfügung stehen. So wäre z.B. neben der bereits erwähnten Toleranzanalyse in Verbindung mit dem Pegelsweep auch eine Toleranzanalyse im Zeitsweep / CW-Modus möglich.

- Eine fortlaufend aktualisierte Toleranzliste für das Zubehör, die die Zuordnung zwischen Zubehörtyp und seinen Toleranzmerkmalen herstellen kann auf dem Netzwerkanalysator abgelegt und z.B. im Rahmen des Firmware-Updates aktualisiert werden kann. Da nahezu alle modernen Netzwerkanalysatoren über einen LAN-Anschluss verfügen, wäre es darüber hinausgehend auch möglich, eine von mehreren Herstellern gepflegt Toleranzliste über das Internet anzubieten, die der Analysator selbstständig nützt. Es wäre dadurch möglich, die lokal im Messgerät verfügbaren Datenbanken regelmäßig zu aktualisieren. Die Toleranzeigenschaften neuer Kalibiersätze, Leistungsmesser, Messkabel würden damit unabhängig von Distributionszyklus neuer Firmware-Versionen zur Verfügung stehen.

Aufgrund der immer kompakteren Bauweise und Verkleinerung der Komponenten bekommt die Messunsicherheit der Messsysteme einen immer höheren Stellenwert. Für die Zukunft werden komplexere mathematischer Modelle benötigt, die zum Beispiel die Temperaturdrift aus der aktuellen Temperatur in die Berechnung mit einbeziehen können. Außerdem werden vom Markt Messunsicherheitsanalysen gefordert werden, die auf spezielle Applikationen zugeschnitten sind. Beispielhaft sollten hier die Bereiche Materialmessung, Antennenmessung, Rückstreumessung genannt werden. Eine andere Anwendung ist die Messgenauigkeitsanalyse bei Time Domain Berechnungen. Berechnungen für die Messunsicherheit werden auch für die aktiven Komponenten gefordert, insbesondere für die Stabilitätsfaktoren. Für die Zukunft könnte auch eine Berechnung der Toleranzanalyse für die Trace Mathematik für weitere Berechnungen hinterlegt werden. So könnten auch Folgefehler mitberücksichtigt werden.

**Patentansprüche**

1. Verfahren zur Bestimmung der Messunsicherheit der Messwerte eines Netzwerkanalysators,
wobei im internen Rechner des Netzwerkanalysators für jeden Messwert der jeweils gewählten Messart mittels Daten, die sich unmittelbar aus den Eigenschaften und dem Betrieb des Netzwerkanalysators ergeben und in dem internen Rechner zugeordneten Datenbanken gespeichert sind und damit für den internen Rechner unmittelbar zugänglich sind, die Messunsicherheit nach Betrag und/oder Phase berechnet und zusammen mit dem jeweiligen Messwert auf der Anzeigeeinrichtung des Netzwerkanalysators angezeigt wird, wobei nur diejenigen Daten von benutzten zusätzlichen Messmitteln, die von den in den Datenbanken bereits gespeicherten Daten abweichen, vom Benutzer zusätzlich von extern in die Datenbanken eingegeben, mit den ursprünglichen dort gespeicherten Daten verrechnet und als neue Daten bei der Messunsicherheitsberechnung benutzt werden,
wobei die für die einzelnen Messwerte berechnete Messunsicherheit als Toleranzschlauch zusammen mit der Messkurve auf der Anzeigeeinrichtung des Netzwerkanalysators graphisch dargestellt wird, und
wobei der Toleranzschlauch um die Messkurve mit einem der Anzeigeskala der Messkurve gegenüber der Anzeigeskala anderen, vergrößerten Maßstab angezeigt wird.

2. Verfahren nach Anspruch 1,
**dadurch gekennzeichnet,**
**dass** die von extern zusätzlich einzugebenden Messmitteldaten über einen den jeweiligen Messmitteln zugeordneten Datenträger in die Datenbanken des internen Rechners eingegeben werden.

3. Verfahren nach einem der vorhergehenden Ansprüche,
**dadurch gekennzeichnet,**
**dass** die von extern einzugebenden zusätzlichen Messmitteldaten für die gängigsten unterschiedlichen Messmittel in einer Datenbank des Netzwerkanalysators aufgelistet und daraus auswählbar sind.

4. Verfahren nach einem der vorhergehenden Ansprüche,
**dadurch gekennzeichnet,**
**dass** die effektiven Systemdaten in Abhängigkeit von unterschiedlichen möglichen Einstellungen des Netzwerkanalysators in den Datenbanken abgelegt sind.

5. Verfahren nach einem der vorhergehenden Ansprüche,
**dadurch gekennzeichnet,**
**dass** die nach Betrag und/oder Phase für eine Messgröße (z. B. Reflexionsfaktor) berechnete Messunsicherheit vor der Anzeige auf eine andere davon abgeleitete Messgröße (z. B. VSWR, Gruppenlaufzeit, Impedanz) umgerechnet und dann zusammen mit dieser abgeleiteten Messgröße angezeigt wird.

6. Verfahren nach einem der vorhergehenden Ansprüche,
**dadurch gekennzeichnet,**
**dass** die nach Betrag und/oder Phase für ein Darstellungsformat (z. B. lineare Darstellung) berechnete Messunsicherheit auf ein anderes Darstellungsformat (z. B. dB- oder logarithmische Darstellung) umgerechnet und angezeigt wird.

7. Verfahren nach Anspruch 5 oder 6,
**dadurch gekennzeichnet,**
**dass** der Toleranzschlauch entsprechend der Häufigkeit der Messwerte unterschiedlich graphisch dargestellt wird.

8. Verfahren nach einem der vorhergehenden Ansprüche,
**dadurch gekennzeichnet,**
**dass** mittels Marker, die längs der angezeigten Messkurve verschiebbar sind, Messkurven-Abschnitte auswählbar sind, für die dann die zugehörigen Messunsicherheitswerte gesondert, vorzugsweise digital, angezeigt werden.

9. Verfahren nach einem der vorhergehenden Ansprüche,
**dadurch gekennzeichnet,**
**dass** im internen Rechner des Netzwerkanalysators aus den in den Netzwerkanalysator eingegebenen Daten eines für die
Pegelkalibrierung verwendeten Leistungsmessers für jeden Messwert die Messunsicherheit nach Betrag und/oder Phase berechnet und zusammen mit dem jeweiligen Messwert angezeigt wird.

**Claims**

1. Method for establishing the measuring uncertainty of the measured values of a network analyser,
wherein the measuring uncertainty is calculated in terms of magnitude and/or phase in the internal computer of the network analyser for each measured value of the type of measurement selected in each case by means of data which are obtained directly from the properties and the operation of the network analyser and stored in associated databases in the internal computer and thus accessible directly to the internal computer, and is displayed together with the respective measured value on the display unit of the network analyser,

wherein only data from additional measuring means used which differ from the data already stored in the databases are additionally entered in the databases by the user from external sources, set off against the data originally stored there and included as new data in the calculation of the measuring uncertainty,

wherein the measuring uncertainty calculated for the individual measured values is displayed graphically in the form of a tolerance band together with the measurement curve on the display unit of the network analyser, and

wherein the tolerance band is displayed around the measurement curve to an enlarged scale different to the display scale used for the measurement curve.

2. Method according to claim 1,
**characterised in that**
the measuring means data to be entered additionally from external sources are entered in the databases of the internal computer by means of a data medium associated with the respective measuring means.

3. Method according to one of the preceding claims,
**characterised in that**
the measuring means data to be entered additionally from external sources are listed for the most common different measuring means in a database of the network analyser and can be selected from it.

4. Method according to one of the preceding claims,
**characterised in that**
the effective system data are stored in the databases dependent on different possible settings of the network analyser.

5. Method according to one of the preceding claims,
**characterised in that**
the measuring uncertainty calculated in terms of magnitude and/or phase for a measured parameter (e.g. reflection coefficient) is recalculated prior to being displayed on a different measured parameter derived from it (e.g. VSWR, group delay time, impedance) and then displayed together with this derived measured parameter.

6. Method according to one of the preceding claims,
**characterised in that**
the measuring uncertainty calculated in terms of magnitude and/or phase for a display format (e.g. linear display) is recalculated for a different display format (e.g. dB or logarithmic display) and displayed.

7. Method according to claim 5 or 6,
**characterised in that**
the tolerance band is displayed graphically differently according to the frequency of occurrence of the measured values.

8. Method according to one of the preceding claims,
**characterised in that**
using markers which can be moved along the displayed measurement curve, measurement curve sections can be selected for which the associated measuring uncertainty values are then displayed separately, preferably digitally.

9. Method according to one of the preceding claims,
**characterised in that**
the measuring uncertainty is calculated in terms of magnitude and/or phase in the internal computer of the network analyser from the data entered in the network analyser from a power meter used for level calibration for each measured value and is displayed together with the respective measured value.

**Revendications**

1. Procédé pour déterminer l'incertitude de mesure de valeurs mesurées d'un analyseur de réseau,
dans lequel, pour chaque valeur mesurée du type de mesure respectivement choisi, l'incertitude de mesure est calculée au moyen de données dans le calculateur interne de l'analyseur de réseau en fonction de la grandeur et/ou de la phase et est affichée en association avec la valeur mesurée respective sur le dispositif d'affichage de l'analyseur de réseau, lesquelles données résultent directement des propriétés et du fonctionnement de l'analyseur de réseau et sont enregistrées dans des bases de données affectées au calculateur interne et auxquelles le calculateur interne peut ainsi directement accéder,
dans lequel seules les données de moyens de mesure supplémentaires utilisés qui s'écartent des données déjà enregistrées dans les bases de données, sont de plus entrées extérieurement par l'utilisateur dans les bases de données, sont compensées avec les données qui y ont été initialement enregistrées et sont utilisées comme des données nouvelles lors du calcul de l'incertitude de mesure,
dans lequel l'incertitude de mesure calculée pour les valeurs mesurées individuelles est présentée graphiquement sur le dispositif d'affichage de l'analyseur de réseau sous la forme d'une bande de tolérance en association avec la courbe de mesure, et
dans lequel la bande de tolérance autour de la courbe de mesure est indiquée avec une échelle agrandie, l'échelle d'affichage de la courbe de mesure étant différente de l'échelle d'affichage.

2. Procédé selon la revendication 1,
**caractérisé en ce que**,
les données des moyens de mesure qui doivent de plus être entrées extérieurement sont entrées dans les bases de données du calculateur interne par l'intermédiaire d'un support de données associé aux moyens de mesure respectifs.

3. Procédé selon l'une des revendications précédentes,
**caractérisé en ce que**
les données des moyens de mesure qui doivent de plus être entrées extérieurement pour les différents moyens de mesure les plus courants sont listées dans une base de données de l'analyseur de réseau et peuvent être sélectionnées à partir de cette liste.

4. Procédé selon l'une des revendications précédentes,
**caractérisé en ce que**
les données effectives du système sont stockées dans les bases de données en fonction de différents réglages possibles de l'analyseur de réseau.

5. Procédé selon l'une des revendications précédentes,
**caractérisé en ce que**
l'incertitude de mesure calculée en fonction de la grandeur et/ou de la phase pour une grandeur mesurée (facteur de réflexion par exemple) est convertie avant l'affichage en une autre grandeur mesurée découlant de celle-ci (VSWR, temps de propagation de groupe, impédance par exemple) et est ensuite affichée en association avec cette grandeur mesurée qui en découle.

6. Procédé selon l'une des revendications précédentes,
**caractérisé en ce que**
l'incertitude de mesure calculée en fonction de la grandeur et/ou de la phase pour un format de présentation (présentation linéaire par exemple) est convertie en un autre format de présentation (présentation en dB ou logarithmique par exemple) et est affichée.

7. Procédé selon la revendication 5 ou 6,
**caractérisé en ce que**
la bande de tolérance est représentée graphiquement de manière différente en fonction de la fréquence d'occurrence des valeurs mesurées.

8. Procédé selon l'une des revendications précédentes,
**caractérisé en ce que**
des parties de courbe de mesure peuvent être sélectionnées au moyen de marqueurs qui peuvent être déplacés le long de la courbe de mesure affichée, et sont ensuite affichées séparément pour les valeurs d'incertitude de mesure associées, de préférence sous forme numérique.

9. Procédé selon l'une des revendications précédentes,
**caractérisé en ce que**
pour chaque valeur de mesure, l'incertitude de mesure est calculée en fonction de la grandeur et/ou de la phase dans le calculateur interne de l'analyseur de réseau, à partir des données d'un mesureur de puissance utilisé pour le calibrage de gain qui ont été entrées dans l'analyseur de réseau, et est affichée en association avec la valeur mesurée respective.

Fig. 1

## Fig. 2

## Fig. 3

## Fig. 4

**Fig. 5**

Flussdiagramm:

$s_{11M}$ → f →

Berechnung der Messunsicherheit für jeden
Messpunkt Betrag und / oder Phase

Betragsunsicherheit — Phasenunsicherheit

ggf. Umrechnung der Unsicherheit auf die
angezeigte Messgröße VSWR, Gruppenlaufzeit, usw.

ggf. Umrechnung der Unsicherheit auf das
Darstellungsformat z.B. komplex, dB-Betrag,...

Umrechnung für die
Intelligente Zoomfunktion

Darstellung im Diagramm

ohne Zoomfunktion

mit Zoomfunktion

Nullpunkt der
Toleranzdarstellung
relativ zur Messkurve

0,1dB
0dB
-0,1dB

**Fig. 7**

Fig. 6

Fig. 8

Trc1       [b2]   – – – –   dB Mag 2 dB / Ref 4 dBm
Mem2[Trc1] [b2]   ————   dB Mag 2 dB / Ref 4 dBm
Mem3[Trc1] [b2]   – · — · —   dB Mag 2 dB / Ref 4 dBm

Ch1     Start -25 dBm       Freq 1 GHz       Stop 0 dBm

**Fig. 9**

Trc1       [S21]   – – – –   dB Mag 1 dB / Ref 16 dB
Mem2[Trc1] [S21]   ————   dB Mag 1 dB / Ref 16 dB
Mem3[Trc1] [S21]   – · — · —   dB Mag 1 dB / Ref 16 dB

Comp.: -13dBm +0,5dB / -0,55dB

Ch1     Start -25 dBm       Freq 1 GHz       Stop 0 dBm

**Fig. 10**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2155189 A
- DE 102004047308 A1
- DE 10211334 A1